# EUROPÄISCHE PATENTSCHRIFT

(11) **EP 1 018 197 B1**
(45) Veröffentlichungstag und Bekanntmachung des Hinweises auf die Patenterteilung: **19.02.2003**
(21) Anmeldenummer: 99963135.1
(22) Anmeldetag: 15.07.1999
(51) Int. Cl.: H01S 5/02, H01S 5/14

(54) **JUSTIERBARES SYSTEM EINES DIODENLASERS MIT EXTERNEM RESONATOR IN DER LITTMAN-KONFIGURATION**
ADJUSTABLE SYSTEM OF A DIODE LASER HAVING AN EXTERNAL RESONATOR IN THE LITTMAN CONFIGURATION
SYSTEME REGLABLE D'UN LASER A DIODE POURVU D'UN RESONATEUR EXTERNE SELON LA CONFIGURATION DE LITTMAN

(30) Priorität: 21.07.1998 DE 19832750
(43) Veröffentlichungstag der Anmeldung: 12.07.2000
(73) Patentinhaber: LPKF Laser & Electronics AG, D-30827 Garbsen/OT Berenbostel (DE)
(72) Erfinder: KICKELHAIN, Jörg, D-31535 Neustadt (DE); SCHULZ, Olaf, D-13086 Berlin (DE)
(74) Vertreter: Braun, Dieter, Dipl.-Ing.
(86) Internationale Anmeldenummer: DE9902162
(87) Internationale Veröffentlichungsnummer: WO00005791

(56) Entgegenhaltungen:
- EP-A- 0 702 438
- EP-A- 0 801 451
- WO-A-94/08371
- WANDT D ET AL: "EXTERNAL CAVITY LASER DIODE WITH 40 NM CONTINUOUS TUNING RANGE AROUND 825 NM" OPTICS COMMUNICATIONS,NL,NORTH-HOLLAND PUBLISHING CO. AMSTERDAM, Bd. 130, Nr. 1/02/03, 15. September 1996 (1996-09-15), Seiten 81-84, XP000624113 ISSN: 0030-4018

## Beschreibung

Diese Erfindung bezieht sich auf ein justierbares System eines Diodenlasers mit externem Resonator in der Littman-Konfiguration, wobei das System ein Beugungsgitter aufweist, ferner einen auf einem drehbaren Tragarm befestigten Spiegel, der drehbar um eine Achse anzuordnen ist, die senkrecht zu der durch die die Laserdiode und das Beugungsgitter verlassenden Strahlen aufgespannten Strahlengang-Ebene und innerhalb der Gitteroberflächen-Ebene verläuft und die zu der Ebene des Endspiegels der Laserdiode und der Ebene der Oberfläche des Spiegels den gleichen Abstand besitzt, ferner ein Stellelement zur Bewegung des Spiegels um die die Spiegeldrehachse bildende Tragarmdrehachse und Mittel zur Justierung der Tragarmdrehachse aufweist, mit denen die Tragarmdrehachse unter festem Winkel zu der Strahlengang-Ebene relativ zu der Laserdiode bewegt werden kann.

Durch die Rückkopplung des Lichtes, das von einer Laserdiode eines Diodenlasers mit externem Resonator emittiert wird, kann die spektrale Breite der Laseremission deutlich reduziert werden. Ein Außenresonator mit einem wellenlängenselektiven Element ermöglicht darüber hinaus das Abstimmen der Laserwellenlänge. Weit verbreitet sind Konfigurationen mit Rückkopplung über ein Reflektionsgitter. Hierbei sind Anordnungen in der sog. Littman-Konfiguration besonders interessant, da die Lage des ausgekoppelten Strahls unabhängig von der Wellenlänge ist. Somit wird durch Abstimmen der Laserwellenlänge die Strahllage nicht verändert (M. Littman and H. Metcalf: Spectrally narrow pulsed dye laser without beam expander, Appl. Opt. 17, 2224 [1978]).

Im Littman-Aufbau verläßt der ausgekoppelte Laserstrahl den Resonator über die nullte Interferenzordnung des Gitters. Das Licht der ersten Gitterordnung trifft auf einen drehbaren Spiegel, welcher das einfallende Licht wieder auf das Gitter zurückreflektiert. Von dort aus wird die erste Interferenzordnung des reflektierten Strahls in die Laserdiode zurückgekoppelt.

Die Wellenlängenabstimmung erfolgt durch Drehen des Spiegels. Da das Gitter nicht bewegt wird, bleibt die Lage des ausgekoppelten Strahls bei der Wellenlängenabstimmung konstant. Ein weiterer wesentlicher Vorteil der Littman-Konfiguration besteht darin, daß der Laserstrahl bei einem Umlauf innerhalb des Resonators zweimal das Gitter passiert. Auf diese Weise erreicht man mit nur einem wellenlängenselektiven Element ein sehr schmales Verstärkungsprofil.

Ein weiter modensprungfreier Abstimmbereich des Diodenlasers mit externem Resonator kann durch synchrones Abstimmen der vom Gitter selektierten Wellenlänge und der Resonatorlänge erzielt werden (K. Liu and M. Littman: Novel geometry for single-mode scanning of tunable lasers, Opt. Lett. 6, 117 [1981]). Dazu muß der Spiegel auf einer Kreisbahn um eine entsprechend gewählte Drehachse bewegt werden.

Wählt man als Drehachse des Spiegels eine Gerade, die die Ebene, in der der Strahlengang des Diodenlasers mit externem Resonator verläuft, senkrecht schneidet und in der Ebene der Gitteroberfläche liegt, so ist dann ein modensprungfreies Abstimmen möglich, wenn die Ebenen, die durch den Endspiegel der Laserdiode und durch die Oberfläche des Spiegels verlaufen, den gleichen Abstand zur Drehachse des Spiegels besitzen (K. Liu and M. Littman: Novel geometry for single-mode scanning of tunable lasers, Opt. Lett. 6, 117 [1981]; P. McNicholl and H. Metcalf: Synchronous cavity mode and feedback wavelength scanning in dye laser oscillators with gratings, Appl. Opt. 24, 2757 [1985]).

Das modensprungfreie Abstimmen mittels Drehung des Endspiegels stellt hohe Anforderung an die Genauigkeit der Positionierung der Drehachse des Spiegels und des Spiegels selbst. In der Regel werden deshalb Diodenlaser mit externem Resonator so aufgebaut, daß die Lage der Drehachse nach Zusammenbau des Lasers exakt justiert werden kann. Um die Rückkopplung des Lichtes vom externen Resonator in den Laserdiodenchip zu optimieren, wird darüber hinaus mindestens eine der Komponenten Laserdiode, Gitter und Spiegel justierbar befestigt.

In der Druckschrift US 5,319,668 ist ein justierbares System für Diodenlaser mit externem Resonator beschrieben. Nachteilig bei diesem justierbaren System ist jedoch, daß zwar der Spiegel selbst in bezug auf eine Drehachse eines Tragarms des Spiegels justierbar ist, die Drehachse des Tragarms jedoch nicht in ihrer Position veränderbar ist. Damit kann zwar der Spiegel bezüglich seiner Drehachse verkippt werden, jedoch ist es nicht möglich, die Drehachse des Tragarms unter einem rechten Winkel zur Strahlengang-Ebene in ihrer Position zu verschieben. Die Lagerung der Drehachse muß exakt vorgegeben sein, was bei dem bekannten justierbaren System durch ein Kugelgelenk gegeben ist. Nachteilig ist bei solch einem Kugelgelenk jedoch, daß es nicht leicht läuft oder ein gewisses Spiel in Kauf genommen werden muß. Ein rauher Lauf des Tragarmlagers verhindert aber ein gleichmäßiges Abstimmen und das präzise Anfahren einer bestimmten Emissionsfrequenz.

In der EP 0 702 438 A1 und in "Optics Communications vol 130 1996 pages 81-84, Wandt et al; Extemal cavity laser diode with 40 nm continous tuning range around 825 nm" ist ein gattungsgemäßes justierbares System beschrieben, bei dem die Drehachse des Tragarms des Spiegels zwar in zwei Richtungen verschoben werden kann, die senkrecht zur Ausrichtung der Drehachse sind und ferner einen rechten Winkel zueinander einnehmen. Bei dieser Anordnung ist jedoch nachteilig, daß die Drehachse nicht verkippt und damit eine Justierung der Rückkopplung des von dem Spiegel reflektierten Laserstrahls in die Laserdiode nicht vorgenommen werden kann.

Der Erfindung liegt daher die Aufgabe zugrunde, ein justierbares System eines Diodenlaser mit externem Resonator in der Littman-Konfiguration zu schaffen, mit dem eine simultane Justierung der Drehachse des Spiegels und der Rückkopplung möglich ist.

Diese Aufgabe wird durch ein gattungsgemäßes justierbares System gelöst wie in Anspruch 1, bei dem ferner Mittel zur Justierung der Tragarmdrehachse vorhanden sind, mit denen der Winkel der Tragarmdrehachse zur Strahlengang-Ebene verändert werden kann.

Das erfindungsgemäße justierbare System weist einen kompakten, mechanisch stabilen Aufbau des Diodenlasers mit externem Resonator auf, wodurch eine hohe Amplituden- und Frequenzstabilität des Laserlichtes erreicht wird, und ermöglicht auf einfache Weise eine simultane Justierung der Drehachse des Spiegels und der Rückkopplung des Laserstrahls in die Laserdiode. Die Drehachse kann exakt senkrecht zur Strahlengang-Ebene justiert werden, wodurch ein Wandern des Strahles auf dem Spiegel vermieden werden kann. Somit können die Anforderungen an die Gleichmäßigkeit der Spiegeloberfläche gesenkt werden. Denn bei einer Wanderung des Strahles auf dem Spiegel variiert während des Abstimmens der Anteil des Lichtes, der derart reflektiert wird, daß er nicht in die Laserdiode zurückgekoppelt wird. Hieraus resultieren Amplitudenschwankungen. Weiterhin ändert sich bei einer Wanderung des Strahles der Resonatorlängenunterschied für verschiedene Teilstrahlen. Während des Abstimmens wird deshalb die Phasenbeziehung zwischen den Teilstrahlen gestört, woraus eine spektrale Verbreiterung des Laseremission resultiert.

Der auf dem Tragarm befestigte Spiegel kann ein totalreflektierendes rechtwinkliges Prisma sein. Dabei ist das Prisma so angeordnet, daß der Strahl durch die Hypothenuse eintritt. Der Vorteil eines solches Prismas anstelle eines Planspiegels besteht darin, daß der in das Prisma eintretende Strahl stets parallel zu dem reflektierten Strahl ist. Der gleiche Vorteil kann auch dadurch erreicht werden, daß der Spiegel durch einen V-förmigen Retroreflektor mit zwei in einem rechten Winkel zusammengefügten Teilspiegeln gebildet ist.

Vorzugsweise ist die Tragarmdrehachse durch zwei höhenverstellbare Gelenke gebildet, die beidseitig der Strahlengang-Ebene angeordnet sind. Mittels dieser unabhängig voneinander einstellbaren Gelenke kann die Tragarmdrehachse in ihrem Winkel zur Ebene des Beugungsgitters auf einfache Weise verändert werden.

Die Tragarmgelenke sind bevorzugt Festkörpergelenke, z. B. aus Federstahl. Damit ist erreicht, daß die Gelenke kein Spiel aufweisen.

Die Drehachsengelenke können derart konstruiert sein, daß sie eine Rückstellkraft besitzen, die bestrebt ist, den Abstand zwischen dem Beugungsgitter und dem Spiegel zu vergrößern. Diese Rückstellkraft kann beispielsweise mittels Spiralfedern verstärkt werden.

Das Stellelement zur Bewegung des Spiegels kann so ausgelegt sein, daß es eine Kraft auf den Tragarm des Spiegels in Richtung des Beugungsgitters ausübt. Dies hat den Vorteil, daß das Stellelement auf der Rückseite des Spiegels bzw. des Tragarms positioniert ist, und damit eine Behinderung des Strahlengangs ausgeschlossen ist. Das Stellelement kann in diesem Fall innerhalb der Strahlengang-Ebene an der Rückseite des Spiegels angreifen. Somit bilden das Stellelement und die beiden Tragarmgelenke zusammen eine stabile Dreipunktlagerung für den Tragarm des Spiegels und damit für den Spiegel.

Das Stellelement weist vorzugsweise mindestens einen piezoelektrischen Aktuator auf. Um einen größeren Wirkungsbereich des Stellelementes zu erreichen, kann auch ein Stapel solcher piezoelektrischen Aktuatoren vorgesehen sein. Alternativ kann für das Stellelement auch eine Schraube, ein Motor oder eine Kombination der genannten Stellelemente vorgesehen sein.

Die Tragarmgelenke sind zur Höhenverstellung vorzugsweise jeweils an einem Verstellelement befestigt, das dadurch höhenverstellbar ist, daß es an einem Sockelelement angelenkt ist. Diese Anlenkung befindet sich auf der der Drehachse gegenüberliegenden parallelen Seite des Verstellelementes bzw. des Sockelelementes. Dabei ist es vorteilhaft, wenn das Verstellelement und das Sockelelement, wenn sie parallel ausgerichtet sind, einen Abstand zueinander aufweisen. Auch die Verstellelement-Gelenke sind vorzugsweise Festkörpergelenke.

Das jeweilige Verstellelement kann eine in vertikaler Richtung durch das Verstellelement hindurchgeführte Justierschraube aufweisen, mit der der Abstand zwischen Verstell- und Sockelelement verändert werden kann.

Ferner ist erfindungsgemäß bevorzugt vorgesehen, daß der Spiegel relativ zu der Laserdiode und dem Beugungsgitter verschiebbar ist, wobei die relative Lage der Laserdiode und des Beugungsgitters zueinander fest sein können. Somit ist die Anzahl der Justiermöglichkeiten geringgehalten, gleichzeitig können jedoch alle notwendigen Freiheitsgrade weiterhin hinreichend genau justiert werden.

Das erfindungsgemäße justierbare System erweist sich auch insofern als vorteilhaft, als daß die Komponenten, die für die Justierung wesentlich sind, einstellbar sind - und nicht zum Teil in ihrer Position in bezug auf eine bestimmte Laserdiode fest vorgegeben sind- , wodurch sich das System auch bei Auswechslung der Laserdiode weiterbenutzen läßt.

Im folgenden wird das erfindungsgemäße justierbare System anhand zweier Ausführungsbeispiele näher erläutert, wobei auf die Figuren Bezug genommen wird, in denen gleiche Teile mit gleichen Bezugszeichen versehen sind. Es zeigen:
Figur 1, eine schematische Seitendarstellung eines erfindungsgemäßen justierbaren Systems;
Figur 2, eine schematische Seitendarstellung einer Bauteilgruppe, die den Tragarm des Spiegels und Mittel zur Justierung der Drehachse des Tragarms aufweist;
Figur 3, eine schematische Darstellung der Bauteilgruppe gemäß Figur 2 von der Seite gesehen, an der der ausgekoppelte Laserstrahl austritt;
Figur 4, eine schematische Prinzipdarstellung der Bauteilgruppe gemäß Figur 3 mit geneigter Tragarmdrehachse und zusätzlich der Laserdiode und des Gitters;
Figur 5, eine schematische Darstellung eines justierbaren Systems, bei dem als Spiegel ein totalreflektierendes rechtwinkliges Prisma verwendet ist;
Figur 6, eine schematische Darstellung des Strahlengangs im Prisma gemäß Figur 5.

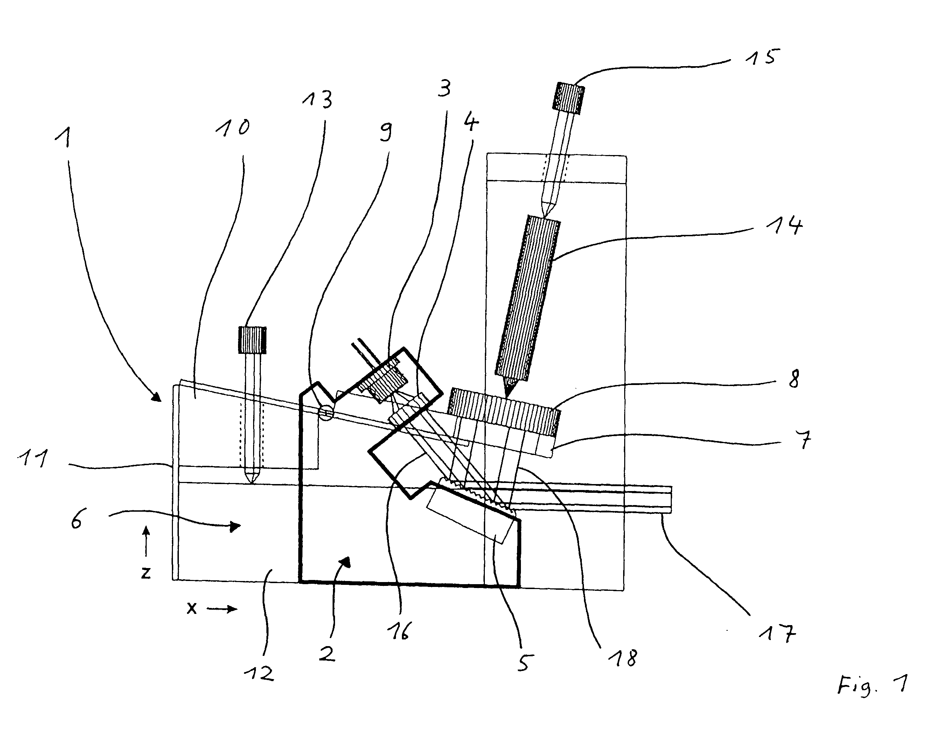

Das justierbare System 1 der Figur 1 weist eine erste Bauteilgruppe 2 auf, die einen Diodenlaser 3, eine Kollimatorlinse 4 und ein Beugungsgitter 5 umfaßt.

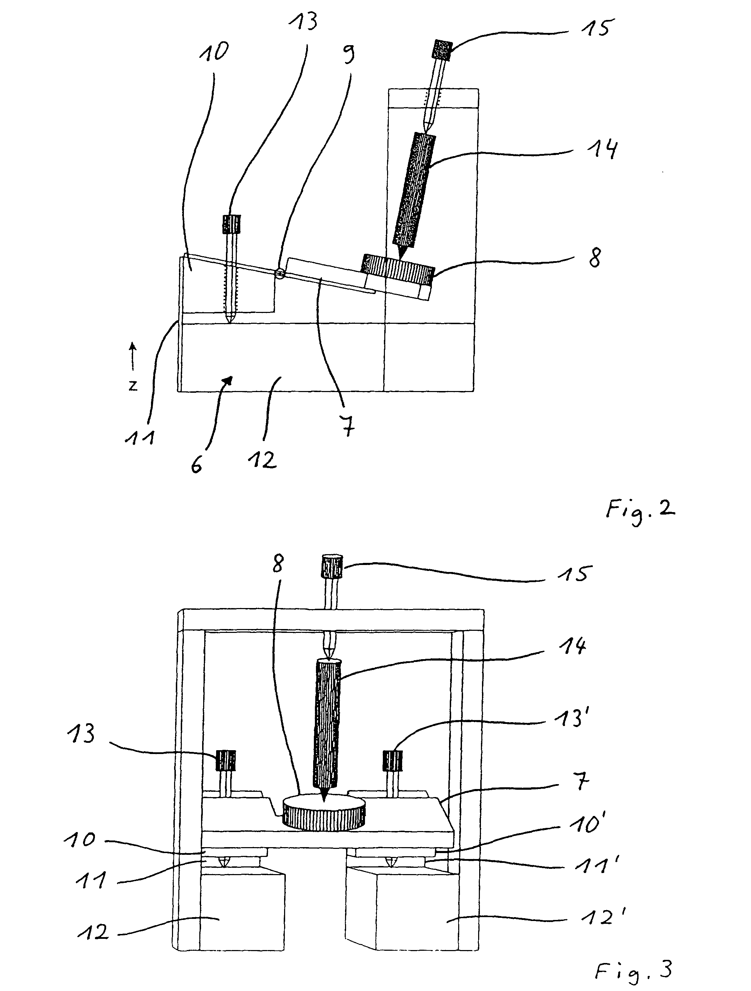

Darüber hinaus weist das justierbare System 1 eine zweite Bauteilgruppe 6 auf, die in Figur 2 separat dargestellt ist. Die Bauteilgruppe 6 besitzt einen Tragarm 7, auf dem ein Spiegel 8 befestigt ist.

Über zwei Festkörpergelenke aus Federstahl, von denen in den Figuren nur eines zu sehen und mit dem Bezugszeichen 9 bezeichnet ist, ist der Tragarm 7 an zwei Verstellelementen 10 und 10' befestigt (vgl. Figur 3).

Das Verstellelement 10 ist über ein weiteres Federstahl-Festkörpergelenk 11 an einem Sockelelement 12 befestigt. Der Abstand zwischen dem Verstellelement 10 und dem Sockelelement 12 ist mittels einer Justierschraube 13 einstellbar.

An der Rückseite des Spiegels 8 greift ein Stapel 14 piezoelektrischer Aktuatoren an. Oberhalb des Stapels 14 piezoelektrischer Aktuatoren befindet sich eine Feingewinde-Stellschraube 15.

In Figur 3 ist die Bauteilgruppe 6 des justierbaren Systems 1 in Draufsicht auf die Seite gezeigt, an der die ausgekoppelten Strahlen austreten. Es sind somit das zweite Verstellelement 10', ein zweites Sockelelement 12' und ein weiteres Federstahl-Festkörpergelenk 11' zu sehen, das diese beiden Elemente verbindet. Ferner ist eine zweite Justierschraube 13' dargestellt, über die die Höhe - also die Position in z-Richtung (vgl. Fig. 2) - des Verstellelementes 10' an der das zugehörige Tragarmgelenk tragenden Seitenkante wie bei dem Verstellelement 10 verändert werden kann.

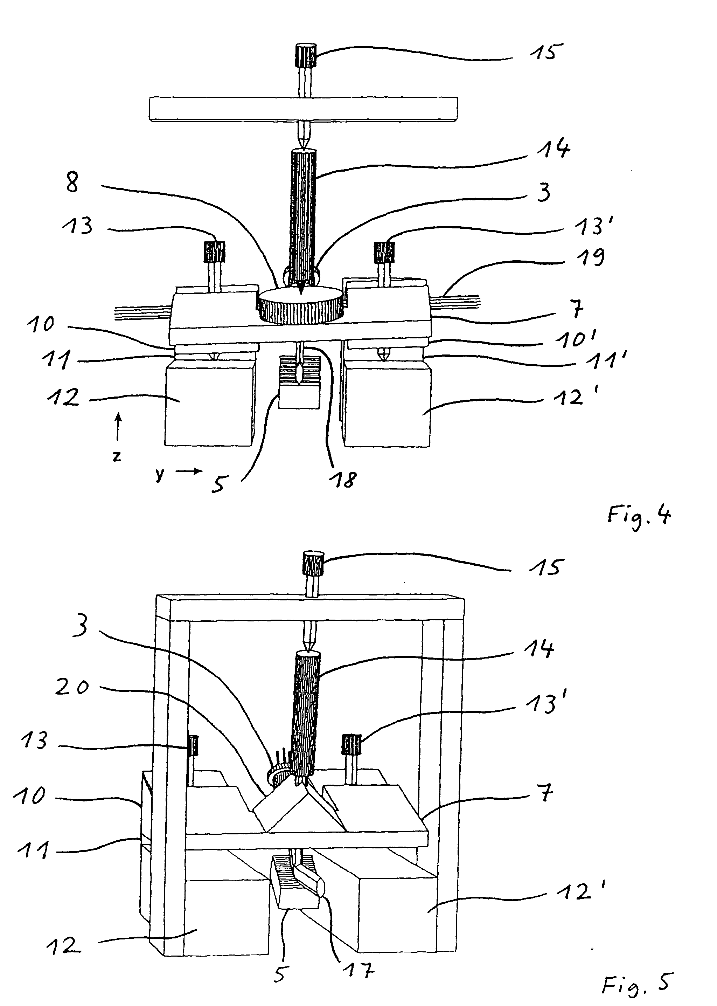

Durch eine Differenz der Höhen der beiden Tragarmgelenke 9 (nur eines ist gezeigt und mit 9 bezeichnet) kann, wie in Figur 4 dargestellt ist, eine Neigung der durch die beiden Tragarmgelenke 9 gebildeten Tragarmdrehachse 19 (zur Verdeutlichung eingezeichnet) sowie des Spiegels 8 in der y-z-Ebene eingestellt werden, d. h. der Winkel der Tragarmdrehachse 19 bzw. des Spiegels 8 zur y-Achse kann eingestellt werden. Durch eine solche Veränderung der Neigung des Spiegels 8 kann die Rückkopplung des Lichtes in die Laserdiode 3 optimiert werden.

Sind die beiden Justierschrauben 13 und 13' unterschiedlich tief eingeschraubt, tritt eine Torsion der Federstähle der Festkörpergelenke 11 bzw. 11' und 9 auf. Für die Neigung des Tragarms 7 und der Tragarmdrehachse 19 werden zum einen die Gelenke 9 auf beiden Seiten der Laserdiode unterschiedlich stark vorgespannt und zum anderen wird die geringe vorhandene Flexibilität der Gelenke 11 und 11' senkrecht zur Tragarmdrehachse ausgenutzt. Die hohe Rückstellkraft bei der Torsion der Federstähle limitiert zwar den Neigungsverstellbereich, durch eine entsprechende Auslegung der Gelenke kann der Neigungsverstellbereich aber an die in der Praxis auftretenden Winkelunsicherheiten angepaßt werden.

Wie aus Figur 1 zu ersehen ist, verlassen die Laserstrahlen - bezeichnet mit 16 - die Kollimatorlinse 4 und treffen auf das Beugungsgitter 5. Die Strahlen 17 der nullten Interferenzordnung des Gitters 5 werden ausgekoppelt und verlassen den Resonator. Die Strahlen 18 der ersten Interferenzordnung werden an dem Spiegel 8 so reflektiert, daß sie wieder auf das Beugungsgitter 5 fallen und in die Laserdiode 3 zurückgekoppelt werden.

Im folgenden wird erläutert, wie die Justierung der Drehachse des Tragarms 7 und der Rückkopplung vorgenommen wird. Zunächst wird die Höhe eines Tragarmgelenks eingestellt, anschließend die Höhe des zweiten Tragarmgelenks so angepaßt, daß eine optimale Rückkopplung durch den Spiegel 8 stattfindet. Dieses Verfahren wird iterativ wiederholt, bis die optimale Lage der Drehachse des Tragarms 7 und damit des Spiegels 8 gefunden ist. Der spektrale Abstand der Modensprünge ist hierbei ein Maß für die Entfernung der Drehachse von ihrer optimalen Lage.

Zur Justierung der Drehachse des Tragarms 7 in x-Richtung kann die in Figur 1 gezeigte Bauteilgruppe 6, die aus dem Spiegel 8, dem Spiegelarm 7, den Drehachsengelenken 9, den Festkörpergelenken 11, 11', den Justierschrauben 13, 13', dem Stapel 14 piezoelektrischer Aktuatoren und der Stellschraube 15 für die Drehung des Spiegels 8 besteht, relativ zu der festen Bauteilgruppe 2 in x-Richtung verschoben und anschließend fixiert werden. Die Bauteilgruppe 2 besteht aus der Laserdiode 3, der Kollimatorlinse 4 und dem Beugungsgitter 5.

Es ist auch eine Ausführungsform möglich, bei der die Stellschraube 15 und der Stapel 14 piezoelektrischer Aktuatoren nicht gemeinsam mit den anderen Bauteilen der Baugruppe 6 verschoben werden, sondern in bezug auf die Laserdiode 3 ortsfest sind.

Die Justierschrauben 13, 13' können auch durch piezoelektrische Aktuatoren sowie Motoren ersetzt oder ergänzt werden. Als Stellelement für die Drehung des Spiegels 8 können auch pneumatische und hydraulische Stellelemente eingesetzt werden.

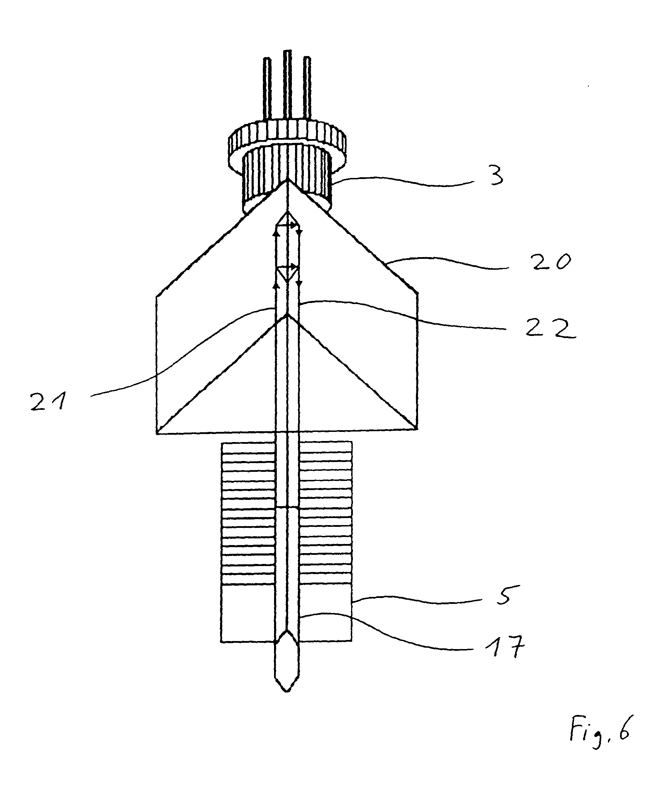

Wie in Figur 5 dargestellt ist, kann anstelle des Planspiegels 8 auch ein totalreflektierendes rechtwinkliges Prisma 20 verwendet werden. In Figur 6 ist der Strahlengang mit dem in das Prisma 20 eintretenden Strahl 21 und dem reflektierten Strahl 22 dargestellt, die stets parallel verlaufen.

## Patentansprüche

1. Justierbares System (1) eines Diodenlasers mit externem Resonator in der Littman-Konfiguration, aufweisend ein Beugungsgitter (5), einen auf einem drehbaren Tragarm (7) befestigten Spiegel (8), der drehbar um eine Achse anzuordnen ist, die senkrecht zu der durch die die Laserdiode (3) und das Beugungsgitter (5) verlassenden Strahlen aufgespannten Strahlengang-Ebene und innerhalb der Gitteroberflächen-Ebene verläuft und die zu der Ebene des Endspiegels der Laserdiode (3) und der Ebene der Oberfläche des Spiegels (8) den gleichen Abstand besitzt, ferner aufweisend ein Stellelement (14, 15) zur Bewegung des Spiegels (8) um die die Spiegeldrehachse bildende Tragarmdrehachse (19) und Mittel zur Justierung der Tragarmdrehachse, mit denen die Tragarmdrehachse unter festem Winkel zu der Strahlengang-Ebene relativ zu der Laserdiode bewegt werden kann, **dadurch gekennzeichnet, daß** ferner Mittel (10, 10', 11, 11', 12, 12', 13, 13') zur Justierung der Tragarmdrehachse (19) vorhanden sind, mit denen der Winkel der Tragarmdrehachse (19) zur Strahlengang-Ebene verändert werden kann.

2. System nach Anspruch 1, **dadurch gekennzeichnet, daß** der auf dem Tragarm (7) befestigte Spiegel (8) ein totalreflektierendes rechtwinkliges Prisma ist.

3. System nach Anspruch 1 oder 2, **dadurch gekennzeichnet, daß** die Tragarmdrehachse (19) durch zwei unabhängig voneinander höhenverstellbare Gelenke (9) gebildet ist, die beidseitig der Strahlengang-Ebene angeordnet sind.

4. System nach Anspruch 3, **dadurch gekennzeichnet, daß** die Tragarmgelenke (9) Festkörpergelenke sind.

5. System nach einem der vorhergehenden Ansprüche, **dadurch gekennzeichnet, daß** das Stellelement (14, 15) zur Bewegung des Spiegels (8) eine Kraft in Richtung des Beugungsgitters (5) auf den Tragarm (7) ausübt.

6. System nach einem der vorhergehenden Ansprüche, **dadurch gekennzeichnet, daß** das Stellelement einen piezoelektrischen Aktuator (14) aufweist.

7. System nach einem der Ansprüche 3 bis 6, **dadurch gekennzeichnet, daß** die Tragarmgelenke (9) jeweils an einem Verstellelement (10, 10') befestigt sind, das dadurch höhenverstellbar ist, daß es an einem Sockelelement (12, 12') angelenkt ist.

8. System nach Anspruch 7, **dadurch gekennzeichnet, daß** das Verstellelement (10, 10') und das Sockelelement (12, 12'), wenn sie parallel ausgerichtet sind, einen Abstand zueinander aufweisen.

9. System nach Anspruch 7 oder 8, **dadurch gekennzeichnet, daß** die Verstellelement-Gelenke (11, 11') Festkörpergelenke sind.

10. System nach einem der Ansprüche 7 bis 9, **dadurch gekennzeichnet, daß** das jeweilige Verstellelement (10, 10') eine Justierschraube (13, 13') zur Veränderung des Abstands zwischen dem Verstellelement und dem Sockelelement (12, 12') aufweist.

11. System nach einem der vorhergehenden Ansprüche, **dadurch gekennzeichnet, daß** der Spiegel (8) relativ zu der Laserdiode (3) und dem Beugungsgitter (5) verschiebbar ist.

## Claims

1. Adjustable system (1) of a diode laser with an external resonator in the Littman configuration, comprising a diffraction grid (5), a mirror (8) fastened to a rotatable carrier arm (7) and which is to be rotatably arranged about an axis extending perpendicular to the beam path plane spanned by the beams leaving the laser diode (3) and the diffraction grid (5), and within the grid surface plane, the beam path plane having the same distance from the plane of the end mirror of the laser diode (3) and the plane of the surface of the mirror (8), also comprising a correcting element (14, 15) for moving the mirror (8) about the carrying arm axis of rotation (19) forming the axis of rotation of the mirror and means for adjusting the carrying arm axis of rotation, with which the carrying arm axis of rotation can be moved relative to the laser diode at a fixed angle to the beam path plane, **characterised in that** there are also means (10, 10', 11, 11', 12, 12', 13, 13') for adjusting the carrying arm axis of rotation (19), with which the angle of the carrying arm axis of rotation (19) to the beam path plane can be changed.

2. System according to claim 1, **characterised in that** the mirror (8) fastened to the carrying arm (7) is a totally reflecting right-angled prism.

3. System according to claim 1 or 2, **characterised in that** the carrying arm axis of rotation (19) is formed by two joints (9) which can be adjusted in height independently of one another and are arranged on both sides of the beam path plane.

4. System according to claim 3, **characterised in that** the carrying arm joints (9) are solid joints.

5. System according to any of the preceding claims, **characterised in that** the correcting element (14, 15) exerts a force on the carrying arm (7) in the direction of the diffraction grid (5) to move the mirror (8).

6. System according to any of the preceding claims, **characterised in that** the correcting element has a piezoelectric actuator (14).

7. System according to any of claims 3 to 6, **characterised in that** the carrying arm joints (9) are each fastened to an adjusting element (10, 10') which can be adjusted in height **in that** it is articulated to a base element (12, 12').

8. System according to claim 7, **characterised in that** the adjusting element (10, 10') and the base element (12, 12') are spaced apart from one another when they are aligned in parallel.

9. System according to claim 7 or 8, **characterised in that** the adjusting element joints (11, 11') are solid joints.

10. System according to any one of claims 7 to 9, **characterised in that** the respective adjusting element (10, 10') has an adjusting screw (13, 13') for changing the spacing between the adjusting element and the base element (12, 12').

11. System according to any of the preceding claims, **characterised in that** the mirror (8) can be displaced relative to the laser diode (3) and the refraction grid (5).

## Revendications

1. Système ajustable (1) d'un laser à diode avec résonateur externe dans la configuration de Littman, présentant un réseau de diffraction (5), un miroir (8) fixé sur un bras support rotatif (7) et à disposer de manière à pouvoir tourner autour d'un axe, qui est orienté perpendiculairement au plan de la trajectoire des rayons formé par les rayons quittant la diode du laser (3) et le réseau de diffraction (5) et dans le plan de la surface du réseau et qui possède la même distance par rapport au plan du miroir final de la diode du laser (3) et au plan de la surface du miroir (8), présentant en outre un élément de réglage (14, 15) pour déplacer le miroir (8) autour de l'axe de rotation du bras support (19) formant l'axe de rotation du miroir et des moyens pour ajuster l'axe de rotation du bras support permettant de déplacer l'axe de rotation du bras support par rapport à la diode du laser sous un angle fixe par rapport au plan de la trajectoire des rayons, **caractérisé en ce que** des moyens (10, 10', 11, 11', 12, 12', 13, 13') sont en outre prévus pour ajuster l'axe de rotation du bras support (19), permettant de modifier l'angle de l'axe de rotation du bras support (19) par rapport au plan de la trajectoire des rayons.

2. Système selon la revendication 1, **caractérisé en ce que** le miroir (8) fixé sur le bras support (7) est un prisme rectangulaire à réflexion totale.

3. Système selon la revendication 1 ou 2, **caractérisé en ce que** l'axe de rotation du bras support (19) est formé par deux articulations (9) réglables en hauteur indépendamment l'une de l'autre, qui sont disposées de part et d'autre du plan de la trajectoire des rayons.

4. Système selon la revendication 3, **caractérisé en ce que** les articulations du bras support (9) sont des articulations à corps solide.

5. Système selon l'une des revendications précédentes, **caractérisé en ce que** l'élément de réglage (14, 15) exerce, pour déplacer le miroir (8), une force sur le bras support (7) en direction du réseau de diffraction (5).

6. Système selon l'une des revendications précédentes, **caractérisé en ce que** l'élément de réglage présente un actuateur piézo-électrique (14).

7. Système selon l'une des revendications 3 à 6, **caractérisé en ce que** les articulations du bras support (9) sont fixées chacune à un élément de réglage (10, 10') qui est réglable en hauteur par le fait qu'il est articulé sur un élément de socle (12, 12').

8. Système selon la revendication 7, **caractérisé en ce que** l'élément de réglage (10, 10') et l'élément de socle (12, 12') sont distants l'un de l'autre lorsqu'il sont parallèles l'un à l'autre.

9. Système selon la revendication 7, **caractérisé en ce que** les articulations de l'élément de réglage (11, 11') sont des articulations à corps solide.

10. Système selon l'une des revendications 7 à 9, **caractérisé en ce que** l'élément de réglage (10, 10') présente une vis de réglage (13, 13') pour modifier l'écart entre l'élément de réglage et l'élément de socle (12, 12').

11. Système selon l'une des revendications précédentes, **caractérisé en ce que** le miroir (8) peut être déplacé par rapport à la diode de laser (3) et au réseau de diffraction (5).
